# EUROPEAN PATENT APPLICATION

(11) **EP 4 514 077 A1**
(43) Date of publication of application: **26.02.2025**
(21) Application number: 23193126.2
(22) Date of filing: 24.08.2023
(51) Int. Cl.: H05K 3/46, H05K 3/28, H05K 3/38

(54) **COMPONENT CARRIER WITH HYDROPHOBIC PROTECTION FILM, AND MANUFACTURING METHOD**

(71) Applicant: AT & S Austria Technologie & Systemtechnik Aktiengesellschaft, 8700 Leoben-Hinterberg (AT)
(72) Inventor: Trischler, Heinrich, 8793 Trofaiach (AT); Weidinger, Gerald, 8700 Leoben (AT); Schlaffer, Erich, 8642 St. Lorenzen (AT); Moser, Peter, 8700 Leoben (AT); Brosch, Michaela, 8720 Knittelfeld (AT)
(74) Representative: Dilg, Haeusler, Schindelmann Patentanwaltsgesellschaft mbH

(57) **Abstract**

There is described a component carrier (100), which comprises:
i) a stack (101) comprising at least one electrically conductive layer structure (104) and at least two electrically insulating layer structures (102);
ii) a cavity (110) formed in the stack (101); and
iii) at least one hydrophobic protection film (120) arranged on at least part of an inner surface of the stack (101) delimiting said cavity (110).

## Description

### Field of the Invention

The invention relates to a component carrier with a stack comprising at least one electrically conductive layer structure and at least two electrically insulating layer structures, wherein a cavity formed in the stack, and wherein at least one hydrophobic protection film is arranged in the cavity. Further, the invention relates to a method of manufacturing said component carrier.

Accordingly, the invention may relate to the technical field of component carriers, such as printed circuit boards or IC substrates.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular, forming a cavity in a circuit board may be a challenge, when said cavity should at the same time fulfill a technical purpose or functionality, for example serve as a wave guide in radio frequency applications.

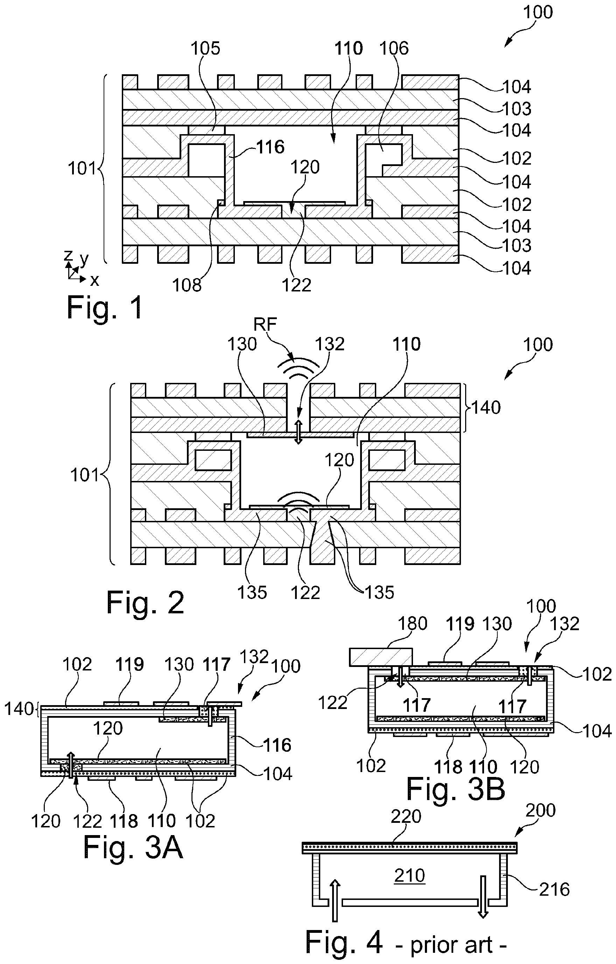

**Figure 4** shows a conventional circuit board 200 with a cavity 210. The bottom and the sidewalls 216 of the cavity 210 are metallized and formed from copper. On top of the cavity 210, there is arranged a roof 220. Further, at the bottom of the cavity 210, there is formed an inlet and an outlet, respectively. This design can be termed an "air-filled substrate integrated waveguide (AFSIW)". An illustrative description of an AFSIW can be summarized as follows: shining with an electromagnetic wave (light) through a small slot into a rectangular channel (the AFSIW cavity) equipped with mirrors on top and bottom. The light will be reflected inside AFSIW on the roof and on the bottom and it will come out at the openings on the other end (antenna). It is ultra-low loss simply because the channel is completely closed and equipped with mirrors; there is only dry air in the channel, so nothing can disturb the travelling of light.

AFSIWs are known structures suitable in particular for low loss HF signal transmission, wherein the size of an AFSIW is dependent on the applied frequency. An AFSIW generally comprises a feeding port, that can be any structure on the bottom or top of the AFSIW structure that allows feeding an HF signal into the AFSIW and guiding it out of the same. In order to obtain a reliable functioning, low loss AFSIW, a proper alignment of a feeding line structure and AFSIW sidewalls may be required, since a misalignment may result in signal loss and therefore in a low quality AFSIW product. Thus, providing an efficient and reliable component carrier cavity, in particular for a wave guide application, may be seen as a challenge.

Furthermore, a component carrier cavity, such as the above-described AFSIW, may be prone to wear and tear, in particular corrosion (e.g. due to fluids such as water or moisture that may enter the cavity). Specifically, since at least part of the stack that delimits the cavity comprises metal surfaces, there may be a specific danger of corrosion, which may in turn significantly lower the product quality.

### Summary of the Invention

There may be a need to provide a cavity, in particular for a wave guide application, for a component carrier layer stack with efficient and reliable properties.

A component carrier and a manufacturing method are described.

According to an aspect of the invention, there is described a component carrier, which comprises:
i) a (layer) stack comprising at least one electrically conductive layer structure and at least two electrically insulating layer structures (e.g. in bottom and lid);
ii) a cavity formed in the stack; and
iii) at least one hydrophobic protection film arranged on at least part of an inner surface (e.g. at the cavity bottom) of the stack delimiting said cavity.

According to a further aspect of the invention, there is described a method of manufacturing a component carrier, wherein the method comprises:
i) providing a stack comprising at least one electrically conductive layer structure and at least two electrically insulating layer structure;
ii) forming a cavity in the stack; and
iii) covering, in particular by screen printing, at least part of an inner surface of the stack, delimiting the cavity, with at least one hydrophobic protection film.

In the context of the present document, the term "hydrophobic protection film" (or hydrophobic protection layer or hydrophobic protection ink or hydrophobic protection coating) may particularly denote a thin layer (film-like layer structure) of material that comprises hydrophobic properties. In an embodiment, a hydrophobic protection film may be provided onto a surface of an electrically conductive layer structure and/or an electrically insulating layer structure, hereby serving as a protection layer. For example, a metal layer may be protected from corrosion using the hydrophobic protection film, since water and other fluids/liquids may be kept away due the hydrophobic properties. In another example, an electrically insulating material, for example an (organic) polymer, may be protected from decomposition (e.g. dissolution or swelling) using the hydrophobic protection film, since water and/or polar organic solvents may be kept away due to the hydrophobic properties. In another embodiment, the hydrophobic protection film may cover an opening, for example an access hole to the cavity. Thereby, the inside of the cavity may be protected against fluid (in particular liquid) from the outside. Yet, the hydrophobic protection film may be permeable for gas and/or electromagnetic waves and/or sonic waves, thereby enabling at the same time a protection function and a technical application function. In a further embodiment, the hydrophobic protection film may be formed inside of an opening, e.g. fill said opening as a hydrophobic protection (filling) material. Yet, the hydrophobic protection film may be electrically insulating. The hydrophobic protection film may comprise organic material and/or inorganic material.

Further below, potential compounds/material for forming such a hydrophobic protection film are described. In one example, a mixture of components such as a toughening resin, a flexibilizing hardener, a basic hardener, a defoamer, a functional filler, and a cross-linking agent may be used (polymer, organic hydrophobic protection film).

In another example, the hydrophobic protection film may comprise an inorganic material, e.g. glass (in particular silicon dioxide). In an example, the hydrophobic protection film may comprise two main surfaces, wherein the two main surfaces comprise a different adhesion property (e.g. hydrophobic and hydrophilic.

In the context of the present document, the term "component carrier" may particularly denote any support structure which is capable of accommodating one or more components thereon and/or therein for providing mechanical support and/or electrical connectivity and/or thermal conductivity. In other words, a component carrier may be configured as a mechanical and/or electronic and/or thermal carrier for components. In particular, a component carrier may be one of a printed circuit board, an organic interposer, a metal core substrate, an inorganic substrate and an IC (integrated circuit) substrate. A component carrier may also be a hybrid board combining different ones of the above mentioned types of component carriers.

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

According to an exemplary embodiment, the invention may be based on the idea that a cavity, in particular for a wave guide application, for a component carrier layer stack with efficient and reliable properties can be provided, when at least one hydrophobic protection film is arranged on at least a part of an inner surface of the stack delimiting said cavity. Preferably the cavity may have an extension of at least 400 µm in stack thickness direction.

The hydrophobic protection film may be formed inside of the cavity, on a sidewall, the bottom or the top of the cavity, thereby protecting in particular metal surfaces within the cavity from corrosion. Preferably, the hydrophobic protection film is stable enough for a temperature higher than 200 °C, in particular 259° C (during component carrier manufacture), can be applied with standard component carrier production processes (e.g. on smooth copper structures of component carrier inner- and outer layers), and may be suitable for economic mass production.

Further advantages of the described hydrophobic protection film within the cavity may include at least one of a permeability for electromagnetic waves (e.g. in a radar application), especially for wave guide applications; robust adhesion to metal/copper, specifically coating of metallized cavity walls and/or antenna coating; release properties after a lamination process; being non-plateable by metal/copper; adhesive functionality with e.g. crack inhibition and CTE mismatch tolerance; heat conductive (coating) functionality. In an example, the hydrophobic protection film may be easily provided by lamination and/or (spray) dispensing and may have release layer properties (no further release layer may then be required). Such a dispensing technique may be feasible. This may be done like painting a car, where hundreds of tiny droplets are created (for example by a nozzle or jet (micro jet dispenser/micro spraying)) and are applied on dedicate areas (e.g. surface area of the cavity).

During component carrier manufacture, the hydrophobic protection film may also be used as a protection coating for a selective (micro-) etching process or a selective metal, in particular copper, formation process, for example (electrochemical) plating or electroless plating.

The described hydrophobic protection film may be applied in a wide variety of different cavities of component carrier layer stacks. Thereby, a straightforward implementation into existing production lines may be enabled, as well as a high design flexibility.

### Exemplary Embodiments

According to an embodiment, the at least one hydrophobic protection film comprises a toughening (and base) resin (for example a prepolymer). In particular, the toughening resin is provided with a weight percentage in a range from 30% to 80%, in relation to an entire weight of the at least one hydrophobic protection film. A toughening resin may be in particular a resin that enhances toughness and resistance of a coating. The toughening resin may thus provide the advantage of inhibiting crack formation/propagation, thereby ensuring a better durability and quality of the at least one hydrophobic protection film. The toughening resin may also serve as a base resin, which may provide curing and/or viscosity properties, in particular may be temperature-stable.

Further examples of a toughening/base resin may include carboxyl-terminated poly (butadiene-co-acrylonitrile)-EP (diglycidylether of bisphenol-A(F, A/F) (DGEBA(F, A/F)). Generally, all epoxy-polymers with blocks of non-reactive spacers may be used to introduce flexibility into the formulation. Further alternatives can be all carboxyl-terminated butadiene acrylonitriles (CTBN), modified BPA's (bisphenol A) and EO (polyethoxy) and PO (polypropoxy) modified BPA's. A further example comprises cyclohexanedimethanol diglycidylether resin.

According to a further embodiment, the at least one hydrophobic protection film comprises a flexibilizing hardener (e.g. a polyolamine). In particular, the flexibilizing hardener is provided with a weight percentage in a range from 1% to 15%, in relation to an entire weight of the at least one hydrophobic protection film. A flexibilizing hardener may be in particular understood as a compound/material that functions as a hardener (see below), but further provides flexible properties, e.g. to a coating. The flexibilizing hardener may thus provide the advantage of flexible properties (to the at least one hydrophobic protection film). Further, the adhesion properties and/or further functionalities may be improved. In an example, the flexibilizing hardener may be configured as a polymer softening block. A non-functional block spacers may serve as a polymer softener within the polymer chain. In another example, the flexibilizing hardener may provide a curing functionality. Well suited as flexibilizing hardeners can be for example polyaliphatic compounds, poly-ethoxy and propoxy compounds and polybutadiens with amine end groups. Basically all spacers with amine end groups can be suitable as flexibilizing hardeners (e.g. siloxanes).

According to a further embodiment, the at least one hydrophobic protection film comprises a (basic) hardener (e.g. dicyandiamide, a chain aliphatic polyamine (such as diethylenetriamine, diproprenediamine), a alicyclic polyamine (e.g. isophoronediamine), or an aromatic amine (e.g. diaminodiphenylmethane)). In particular, the basic hardener is provided with a weight percentage in a range from 1% to 5%, in relation to an entire weight of the at least one hydrophobic protection film. A hardener may be in particular understood as a compound/material that serves as a curing agent to initiate/promote hardening/curing of a material such as a resin. The hardener may provide advantageous properties (to the at least one hydrophobic protection film) regarding curing, e.g. regulation of curing speed. Curing speed may also be influenced positively by an accelerator compound.

According to a further embodiment, the at least one hydrophobic protection film comprises a defoamer (in particular at least one of the following: mineral oil defoamer, a silicone-free defoamer, polysiloxane,). In particular, the defoamer is provided with a weight percentage in a range from 0.5% to 2%, in relation to the entire weight of the at least one hydrophobic protection film. A defoamer (anti-foamer) may be in particular understood as a compound/material suitable to serve as an anti-foaming agent which is reducing/elimination the formation of foam. The defoamer may thus provide the advantage of foam breaking properties (to the at least one hydrophobic protection film), and may thereby support specific applications.

According to a further embodiment, the at least one hydrophobic protection film comprises a wetting agent. In particular, the wetting agent is provided with a weight percentage in the range from 0.5 to 2%, in relation to the entire weight of the at least one hydrophobic protection film.

In an example, the wetting agent can include at least one of the following: polysiloxane, fluorine comprising wetting agent, polyacrylate, polyalkoxylate, polymaleate. A wetting agent may act as a surfactant and reduce the surface tension at an interface (e.g. of oil and water). A wetting agent may thus provide the advantage of preventing a total volume of a material, in particular the at least one hydrophobic protection film, from shrinkage and thereby enhances the integrity of the material, in particular the at least one hydrophobic protection film. In an example, a fluorinated polyacrylate may be applied.

According to a further embodiment, the at least one hydrophobic protection film comprises a leveling agent. In particular, the leveling agent is provided with a weight percentage in the range from 0.5 to 2%, in relation to the entire weight of the at least one hydrophobic protection film.

In an example, the leveling agent can include at least one of the following: polysilane, polysiloxane, polyepoxide, polyacrylate. A leveling agent may be configured to reduce an irregularity of a surface. A leveling agent may thus provide the advantage of enhancing the chemical resistance of a material, in particular the at least one hydrophobic protection film, and thereby enhances the integrity of the material, in particular the at least one hydrophobic protection film. In an example, a silicone acrylate copolymer may be applied.

According to a further embodiment, the at least one hydrophobic protection film comprises an emulsifying agent. In particular, the emulsifying agent is provided with a weight percentage in the range from 0.5 to 10%, in relation to the entire weight of the at least one hydrophobic protection film.

In an example, the emulsifying agent can include at least one of the following: cellulose nitrate, 2-methacryloyloxyethyl phosphorylcholine n-butyl methacrylate copolymer (PMB), citric acid monoglyceride esters. An emulsifying agent may be understood as a substance that stabilizes an emulsion (e.g. oil and water mixture). The emulsifying agent may act as a surfactant and reduce the surface tension at an interface (e.g. of oil and water). An emulsifying agent may thus provide the advantage of emulsifying properties (to the at least one hydrophobic protection film), and may thereby support specific applications.

According to a further embodiment, the at least one hydrophobic protection film comprises a functional filler (e.g. a modified silica and/or cellulose nitrate, aerogel, in particular silica based aerogel; PTFE particles, in particular porous PTFE particles). In particular, the functional filler is provided with a weight percentage in a range from 10% to 40%, in relation to an entire weight of the at least one hydrophobic protection film. A functional filler may be understood in particular as a material being filled into another material, for example filler particles in a matrix material. Thereby, specific functional properties may be enhanced, for example the Young's modulus. The functional filler may thus provide special functionalities in an advantageous manner. In an example, a hydrophobic protection film for covering/protecting a metal surface may comprise PTFE functional fillers. In another example, a hydrophobic protection film for covering an opening (and being porous) may comprise modified silica and/or cellulose nitrate functional fillers. In a further example, the functional filler may have a monodisperse or a polydisperse particle size distribution in the rage between 10 nm to 10 µm. In another example, the functional filler may have spherical and or elliptical shape.

According to a further embodiment, the at least one hydrophobic protection film comprises a cross-linking agent (e.g. epoxidized castor oil (triglycidylether), epoxidized soybean oil, or stearyl glycidyl ester). In particular, wherein the cross-linking agent is provided with a weight percentage in a range from 5% to 45%, in relation to an entire weight of the at least one hydrophobic protection film. A cross-linking agent may be understood as a compound/material suitable to initiate/promote a cross-linking (reaction), i.e. a formation of chemical bonds in another material. For example, a cross-linking agent may promote the formation of chemical bonds in a resin during curing. Thus, a cross-linking agent could also be interpreted as a curing agent. Using the cross-linking agent, the at least one hydrophobic protection film may be cured/hardened in a more efficient and stable manner. In a further example, siloxaneglycidylether is applied.

In an example, epoxidized soybean oil or any other epoxidized natural oil (need to have double bonds to be able to be epoxidized) may be applied. The modified oils can also impart hydrophobicity which may be a desired property of the coating. In an example, all poly-functional epoxides can act as a crosslinker and form a three dimensional network.

According to a further embodiment, the at least one hydrophobic protection film is (at least partially) porous, in particular comprises an open-pore structure. The formation of pores may make the at least one hydrophobic protection film permeable at least for specific functionalities. Furthermore, the at least on hydrophobic protection film may have less weight, while still having reliable mechanical properties. In an example, the at least one hydrophobic protection film may comprise micro-pores and/or meso-pores and/or macropores. In a further example, the at least one hydrophobic protection film may comprise a closed-pore structure. In a preferred example, the open-pore structure may be filled with a fluid, for example a gas, in particular air.

According to a further embodiment, the at least one hydrophobic protection film is gas-permeable (in particular due to the pore formation). Thus, gas such as air may stream in and out of the cavity, thereby enabling a ventilation. Furthermore, this may bring the advantage of an exchange of pressure between the cavity and the environment resulting in not damaging or deforming the cavity during at least one manufacturing process or in use. According to a further embodiment, the cavity is configured to be filled with a fluid, in particular a gas, more in particular air.

According to a further embodiment, the at least one hydrophobic protection film is impermeable for (at least some) liquids. Thereby, it may be efficiently avoided that fluids such as water enter the cavity and lead to corrosion. In an example, the at least one hydrophobic protection film is impermeable for moisture.

According to a further embodiment, the at least one hydrophobic protection film is permeable for electromagnetic waves, in particular radiofrequency (RF) waves. This may provide the advantage that RF waves can enter and/or leave the cavity, thereby enabling an antenna/radar functionality, in particular using a wave guide.

According to a further embodiment, the at least one hydrophobic protection film is permeable for sonic waves. This may provide the advantage that the cavity can be used for microphone/loudspeaker applications.

According to a further embodiment, the cavity is configured as a wave guide for radiofrequency waves. Thus, the cavity, with its above-described advantages, can be used for efficient wave guide applications (e.g. AFSIW, see above). The term "wave guide" may in particular refer to a structure suitable to guide an RF wave within. In general, a wave guide may comprise a volume such as a cavity for the wave propagation. In an example, at least part of the sidewalls of the wave guide are metallized, thereby enhancing the wave propagation. Accordingly, the described cavity may be especially suitable for such a wave guide application.

According to a further embodiment, the hydrophobic protection film at least partially covers a coupling structure for coupling radiofrequency waves into the cavity. In a basic embodiment, such a coupling structure may be an electrically conductive layer structure. In a more advanced embodiment, such a coupling structure may include one or more antenna structures, in particular electrically connected to the cavity. Such a coupling structure (in particular comprises metal such as copper) may be efficiently protected by the hydrophobic protection film. According to a further embodiment, the at least one hydrophobic protection film covers at least part of an antenna structure coupled to the cavity.

According to a further embodiment, the at least one hydrophobic protection film at least partially covers at least one metallized sidewall of the cavity. Thereby, the metal surfaces (in particular suitable for a wave guide application) may be efficiently protected against corrosion and the lifetime may be increased.

According to a further embodiment, (the structure or the material of) the at least one hydrophobic protection film is temperature-stable up to a temperature of 200 °C or more, in particular 210 °C or more, in particular 250 °C or more. This may provide the advantage that forming/providing the hydrophobic protection film can be directly implemented in a component carrier manufacture process, wherein high temperatures of 200°C or more (e.g. during lamination) are used.

According to a further embodiment, the at least one hydrophobic protection film at least partially covers the at least one electrically conductive layer structure as a corrosion protection. As described above, the hydrophobic protection film may serve for an efficient and reliable protection against fluids (in particular water or moisture and/or oxygen) that enter the cavity. Especially in case of a wave guide application (in particular with metal sidewalls), the corrosion protection may be especially suitable. Thereby, also the performance of high frequency applications may be enhanced.

According to a further embodiment, the at least one electrically conductive layer structure comprises a smooth surface. Such a smooth surface may be better suitable for signal transmission (quality) than a rough surface. However, a connection between an insulating material, such as a resin, and a smooth metal surface may be less stable than on a rough surface. The described hydrophobic protection film may nevertheless establish a stable connection to a smooth metal surface.

In the present context, the term "smooth surface" may refer to surface roughness parameter Ra smaller than 1 µm. Accordingly, the term "rough surface" may refer to a surface roughness parameter Ra larger than 1 µm.

According to a further embodiment, the at least one hydrophobic protection film closes at least one access hole (opening) to the cavity, wherein the access hole provides an access from an exterior of the component carrier or an interior layer of the stack to the cavity. This may provide the advantage that such an access hole (which makes functional flexibility of the component carrier higher) can be protected (against fluids) and kept stable. The hydrophobic protection film may cover said access hole (opening) in an example. Additionally or alternatively, the hydrophobic protection film may be arranged (at least partially) in the access hole, thereby serving as a plug.

According to a further embodiment, the at least one hydrophobic protection film comprises:
i) a first hydrophobic protection film covering at least part of the inner surface of the stack delimiting the cavity at first side, and
ii) a second hydrophobic protection film covering at least part of the inner surface of the stack delimiting the cavity at a second side, in particular at the side opposite to the first side.

The first hydrophobic protection film and the second hydrophobic protection film may comprise the same physical and/or chemical properties or may comprise different properties. Thus, the films can be similar or different, depending e.g. on different functionalities. For example, the first hydrophobic protection film may cover a sidewall or bottom of the cavity, in particular a metal surface, and thereby serve for (corrosion) protection of the surfaces. In a further example, the second hydrophobic protection film may cover (and/or fill) an access hole (opening) of the cavity, thereby serving as a protection of the cavity inlet/outlet. In particular the second hydrophobic protection film may be porous and/or permeable for gases such as air, thereby allowing a ventilation but inhibiting the entrance of liquids.

According to a further embodiment, the at least one hydrophobic protection film has a thickness in a range from 50 nm to 50 µm, in particular in a range from 100 nm to 30 µm. This may provide the advantage that such a little thickness requires little space, making the application even more flexible.

According to a further embodiment, the at least one hydrophobic protection film has a length of at least 100 µm, in particular at least 300 µm. This may provide the advantage that a certain area is covered and in particular protected against corrosion.

According to a further embodiment, side walls of the cavity are substantially vertically straight. Depending on the desired application (e.g. wave guide), straight sidewalls may be preferable. Straight sidewalls may further reflect the manufacture process of the cavity, since some processes (e.g. layer drilling) rather lead to tapering (not straight) sidewalls.

In the present context, the term "substantially vertically straight" may refer to spatial orientation of the sidewalls. Thereby, an angle between one main extension of the component carrier (see Fig 1 x or y extension) and the sidewall is between 85° to 95°, preferably 90°.

According to a further embodiment, at least one side wall of the cavity comprises or consists of metal, in particular copper. In particular, in case of wave guide application, metallic surfaces may enhance quality of RF wave propagation. Further, RF waves may be more easily emitted/received from metal surfaces. Such metal surfaces may be implemented using established component carrier manufacture techniques, thereby including the formation into known manufacture processes.

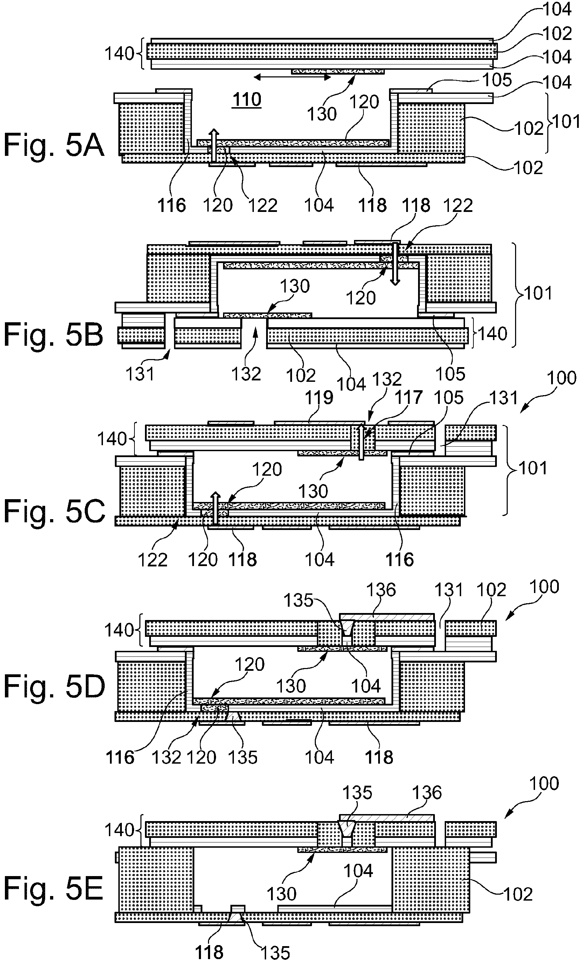

According to a further embodiment, at least one portion of the at least one side wall is free from the hydrophobic protection film, in particular no side wall is in direct contact with the hydrophobic protection film. Since the top or bottom of the cavity may be more prone to corrosion issues and/or since openings are rather formed at the top or bottom of the cavity, the sidewalls require less or no protection by the hydrophobic protection film. This may hold in particular true for embodiments, where the sidewalls are (at least partially) not made of metal (see e.g. Figure 5E).

According to a further embodiment, a metal granulate, in particular a sintered material, is arranged between two electrically conductive layers, in particular wherein the metal (copper) granulate is in direct contact with the cavity (see e.g. reference sign 105). The granulate may be used during the manufacture process, when placing a roof structure (the lid of the cavity) onto the layer stack, thereby closing the cavity. The roof structure may be directly placed on the metal granulate. Further, the metal granulate may separate/protect the cavity from electrically insulating material of the layer stack.

According to a further embodiment, the stack comprises at least one further electrically insulating material, in particular a plug paste (see for example reference sign 106), preferably wherein the further electrically insulating material has a coefficient of thermal expansion (CTE) value smaller than 30 ppm/°C. This may provide the advantage of keeping the cavity free from material of the stack, especially free from electrically insulating material. Further, said material may reflect the manufacture process of forming metal sidewalls for the cavity.

According to a further embodiment, the cavity comprises an input at a first side and an output at a second side, in particular for a high frequency, HF wave, wherein the first side and the second side are at the same side or opposed to each other. Thereby, a plurality of electromagnetic wave based applications may be implemented with a high design flexibility, for example an antenna functionality or a radar functionality.

According to a further embodiment, the input and/or the output is associated with and/or in direct contact with the at least one hydrophobic protection film. Thus, the hydrophobic protection film may be implemented as an efficient protection of the inside of the cavity, yet not hamper an RF wave based functionality.

According to a further embodiment, the component carrier further comprises: another electrically insulating material (see e.g. reference sign 108), in particular a release layer material, arranged in the environment of the cavity, in particular at the same vertical height (z) as the hydrophobic protection film. Said material may be used during the manufacture process to enable a high accuracy, e.g. alignment of the hydrophobic protection film or being a residue of the hydrophobic protection film. In an example, the another electrically insulating material is located at the same vertical height in the layer stack as the hydrophobic protection film.

According to a further embodiment, the cavity comprises a T-shaped cross-section (vertical projection, see for example Figures 1 and 2). This shape may reflect a manufacture step of placing a roof structure as a lid on top of the cavity, leaving a region at the cavity sidewall top free of material.

According to a further embodiment, the stack comprises at least one component (see detailed examples below) embedded in and/or mounted on the stack. For example, the component may be directly connected (electrically) to the inlet or outlet of the cavity, thereby triggering e.g. an RF-based application.

According to a further embodiment, the at least one hydrophobic protection film comprises a T-shape or an L-shape, in particular in a cross-section, in particular wherein the T-shaped or L-shaped part of the hydrophobic protection film is configured as a feeding port for the wave guide. Hereby, the width of the T-shapes or L-shaped, in particular vertical, part may be associated with a wave guide, in particular a frequency of the wave guide.

According to an exemplary embodiment, the at least one hydrophobic protection film is configured as a hydrophobic coating mixture that comprises a silane component and a hydrophobic epoxy component, and can be applied by standard component carrier production processes, for example screen printing processes. The silane component of the mixture can for example comprise 20 - 80 % of benzimidazole-silane and the epoxy component can comprise 20 - 80 % of an elastic modified hydrophobic epoxy component that can comprise (but is not limited to) butyl polybutadiene modified epoxy. Further aspects of the hydrophobic protection film may include its high temperature stability up to 250 °C, not shielding or disturbing high frequency electromagnetic radiation, e.g. above 1 GHz, and a good adhesion on smooth metal/copper structures.

According to an exemplary embodiment, the at least one hydrophobic protection film (dielectric corrosion protection coating) can be used to enable a selective (micro-) etching and selective copper plating process in the component carrier production by coating copper structures that should remain smooth or where a plating process is not desired. Selective etching process can be used to protect copper areas for fiducials.

According to an exemplary embodiment, the viscosity of the corrosion coating (hydrophobic protection coating/film) according to the invention should be suitable for the selected printing method. Different application methods are possible of which screen-printing may be the preferred. In addition, a solvent can be part of the corrosion protective composition.

In the context of the present application, the term "antenna structure" may particularly denote an arrangement of metallic conductor elements electrically connected for instance through a transmission line to a receiver or transmitter. Hence, an antenna structure may be denoted as an electrical member which converts electric power into radio waves, and/or *vice versa.* An antenna structure may be used with a controller (for instance a control chip) such as a radio transmitter and/or radio receiver. In transmission, a radio transmitter may supply an electric current oscillating at radio frequency (i.e. a high frequency alternating current) to the antenna structure's terminals, and the antenna structure may radiate the energy from the current as electromagnetic waves (in particular radio waves). In a reception mode, an antenna structure may intercept some of the power of an electromagnetic wave in order to produce a tiny voltage at its terminals, that may be applied for example to a receiver to be amplified. In embodiments, the antenna structure may be configured as a receiver antenna structure, a transmitter antenna structure, or as a transceiver (i.e. transmitter and receiver) antenna structure. In an embodiment, the antenna structure may be used for a radar application. The antenna structure may, for example, comprise a dipole antenna, a folded dipole antenna, a ring antenna, a rectangular loop antenna, a patch antenna, or a coplanar antenna. The antenna structure may also comprise a yagi antenna or a fractal antenna. A yagi antenna may be a multi-beam directional antenna for so-called mm wave applications. A fractal antenna may be another type of antenna that uses a self-similar design to maximize the length of a material in a total surface area. A fractal antenna may be compact and wideband and can act as an antenna for many different frequencies.

In the context of the present document, the term "radar" may refer to an object-detection that uses electromagnetic waves to determine the range, angle, or velocity of one or more objects. A radar arrangement may comprise a transmitter transmitting electromagnetic waves (e.g. in the radio or microwave range). The electromagnetic waves from the transmitter reflect off the object and return to a receiver. Hereby, one antenna structure may be used for transmitting and receiving. Furthermore, a processor such as an electronic component may be used to determine properties of the object such as location and speed based on the received electromagnetic waves.

According to an embodiment, the at least one hydrophobic protection film (is organic, in particular) comprises a polymer, in particular wherein the at least one hydrophobic protection film comprises two or more agents, wherein each agent is configured to provide a specific functionality (e.g. a toughening resin, a cross-linking agent, etc.). This may bring the advantage of amending the chemical and/or physical properties of the hydrophobic protection film due to the fact that there is a big pool of different combinations agents available. This may simplify to tune the physical and/or chemical properties of the hydrophobic protection layer.

According to an embodiment, the at least one hydrophobic protection film comprises an inorganic material and/or inorganic layer structure, in particular glass (e.g. silicon dioxide), more in particular wherein the hydrophobic protection film is configured as a glass (barrier) layer. This may bring the advantage of (additionally) imparting physical properties, for example tensile strength, to the stack. Furthermore, the inorganic material may prevent the covered portion(s) of the cavity from degradation, for example by oxidation. Moreover, the hydrophobic protection film may be easy to manufacture, which may simplify the manufacturing process.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS₂, CuGaOz, AgAlO₂, LiGaTe₂, AgInSe₂, CuFeS₂, BeO. In the context of the present document, the term "glass barrier layer" may in particular refer to a layer (structure) that comprises glass material and is, at the same time, suitable to fulfill a barrier function, in particular regarding the migration of chemical species.

In this context, the term "glass" may in particular refer to a non-crystalline and amorphous solid. In a preferred example, the glass comprises silicate, in particular silicon dioxide (SiOz). In a further example, the glass comprises at least one silane and/or siloxane compound. In yet another example, the glass may comprise functional groups, e.g. hydrophilic and/or hydrophobic functional groups, in particular at the main surfaces. Since the glass layer is a (continuous or discontinuous) layer, it comprises two main surfaces opposite to each other. Hereby, the two main surfaces can be different in at least one physical/chemical property, specifically regarding their surface tension (surface energy).

In the context of the present document, the term "adhesion property" may in particular refer to the tendency of (dissimilar) particles/surfaces to stick together. An adhesion property may for example be the hydrophilicity or hydrophobicity of a surface. A further adhesion property may be the surface tension or the wettability of a surface. These adhesion properties may overlap with each other. The adhesion property can be imparted through the provision of a functional group on the specific surface.

In the context of the present document, the term "surface tension" may refer to a description of the physical interaction between the surfaces, in particular the surfaces in direct contact, of two substances. The surface tension may be measured as the force per unit length (N/m) or of energy per unit area (J/m²). Even though the term "surface tension" generally refers to liquids and the term "surface energy" would refer to the equivalent property of solids, these terms may be used synonymously in the present context, specifically because the glass of the glass barrier layer may be either seen as a liquid or a solid (chemically, glass is considered as an undercooled liquid).

The surface tension (properties) may be directly linked to the wettability of a surface. For example, the difference in the surface tension of the two main surfaces may be directly seen in a different surface wettability. In an illustrative example, the first main surface may comprise rather hydrophilic properties, while the second main surface may comprise hydrophobic properties. In another example, both main surfaces may comprise hydrophilic properties, yet being different from each other. Yet in another example, both main surfaces may comprise hydrophobic properties, yet being different from each other.

An efficient and robust adhesion to an electrically conductive layer structure may be achieved, when the glass (barrier layer) is used. Further, an efficient and robust adhesion between an electrically conductive layer structure and an electrically insulating layer structure may be achieved. In particular, the glass barrier layer comprises two main surfaces with a different adhesion property (e.g. surface tension (in particular a different wettability)).

While not wishing to be bound to a specific theory, it is believed that the migration of chemical species, such as oxygen from air or moisture, in the resin material is one of the reasons for the long and short time failures of adhesion between a metal and a dielectric. The failure of adhesion of metal to dielectric materials may thus have its origin in the migration of chemical species such as oxygen and/or moisture etc. ions, which may ultimately result in the oxidation of the metal surface, followed by catalytic reactions of formed metal oxides and other substances (eventually also with an adhesion promoter).

Conventional silane or siloxane adhesion promoters for component carriers are generally silane or siloxane monomolecular layers that are deposited by chemical wet processes, e.g. chemical dipping processes, or physical deposition processes, e.g. sputtering, which are therefore not acting as a barrier layer to block chemical substance migration towards the metal surface. Instead, these layer may themselves cause metal corrosion as well as delamination of dielectric material from the metal surface.

It has now been found by the inventors, that a glass barrier layer may be applied with a highly efficient and robust adhesion result, when the glass barrier layer comprises different physical/chemical properties (in particular regarding the adhesion) at its opposite two main surfaces, one of them being optimized for the metal layer structure, while the other one is optimized for the dielectric layer structure (or fluid/air in the cavity). In an example, the main surface in contact with the dielectric layer structure or the fluid in the cavity may be rather hydrophobic, while the main surface in contact with the metal layer structure may be rather hydrophilic.

According to an embodiment, the at least one hydrophobic protection film comprises two main surfaces, and wherein the two main surfaces comprise a different adhesion property (see above). This may bring the advantage of saving space and/or material compared to a stack having two materials having respective one adhesion property stacked over each other. This may simplify the manufacturing process while at the same time ensuring a high quality of the hydrophobic protection film.

According to an embodiment, one of the two main surfaces of the at least one hydrophobic protection film and/or a first layer of the at least one hydrophobic protection film comprises hydrophilic properties. This may bring the advantage of imparting good adhesion to polar surfaces and/or material, for example metal, in particular copper.

According to an embodiment, the other one of the two main surfaces of the at least one hydrophobic protection film and/or a second layer of the at least one hydrophobic protection film comprises hydrophilic properties or hydrophobic properties. This may bring the advantage of imparting good adhesion to apolar surfaces and/or material, for example electrically insulating layer structures.

According to an embodiment, one of the two main surfaces of the at least one hydrophobic protection film and/or a first layer of the at least one hydrophobic protection film comprises at least one functional group for providing the hydrophilic properties. Thereby, the hydrophilic properties may be provided in an efficient and selective manner.

Such hydrophilic properties may be achieved for example by one of the following functional groups: imine, amine, thiol, thioamide, phosphate, hydroxyl, thiazole, imidazole, acrylate, methacrylate, an alcohol group, in particular 3-hydroxypropyl or 2-hydroxyethyl. In an example, acrylate and methacrylate may be preferred silanes for the glass barrier layer. Alcohol groups to be included may in particular comprise 3-hydroxypropyl or 2-hydroxyethyl.

In an example, the first layer comprises a silane/siloxane containing nitrogen groups and/or silane/siloxanes in a mixture with molecules containing a nitrogen group such as 3-ureidopropyltriethoxysilane or siloxane, 3-aminopropyl)tiethoxysilan, trimethoxylsilylbenzotriazole, triallylisocyanurate, divinylbenzimidazole, diallylamine, vinylimidazole, or cyclic azasilane or siloxanes.

According to an embodiment, the other one of the two main surfaces of the at least one hydrophobic protection film and/or a second layer of the at least one hydrophobic protection film comprises at least one functional group for providing the hydrophobic properties.

Such hydrophobic properties may be achieved for example by one of the following functional groups: epoxy, allyl, amine, vinyl, alkyl, anhydride, in particular maleic anhydride, furane, pyrrole, thiophene, and/or a cyclic unsaturated alkene, in particular cyclic pentene. In an example, preferred groups may include alkyl, allyl, vinyl, and a cycle unsaturated alkene.

In a further example, there is used a hydrophobic silane/siloxane especially containing double bonds which will be oxidized in a plasma process, yielding hydrophilic properties. For instance, a hydrophobic allyl-silane double bond can be oxidized in said plasma process into 3-hydroxypropyl, which is hydrophilic.

In a further example, APTES (3-aminopropyl)triethoxysilane, containing no double bonds, will be either oxidized into SiOₓ or polymerized into plasma without oxidation (as there is no double bond) and therefore stay hydrophobic after the plasma process.

According to a further embodiment, the second layer is deposited on the first layer by a (cold) (atmospheric pressure) plasma (spray) process. This may provide an excellent adhesion of the second layer on the first layer.

According to a further embodiment, the second layer comprises functional silanes/siloxanes that form a stable bond with the dielectric material and are either hydrophobic or hydrophilic, depending on the dielectric material (the surface tension of the second layer may be selected according to the surface tension of the dielectric material). The second layer may comprise silane/siloxane functional (organic) groups that react with the dielectric material, such as alcohol, amine, thiol-, epoxy- or double bonds as allyl- groups and a mixture of these groups. Further, functional silanes/siloxanes can be used, such as epoxysilane, epoxysiloxane, aminosilane, aminosiloxane, allylsilane, allylsiloxane, hexamethyldisiloxane.

According to a further embodiment, the at least one hydrophobic protection film comprises silicon dioxide (SiOz), in particular at least one silane and/or siloxane compound/component. This may provide the advantage that an established and cost-efficient industry material can be directly applied and eventually functionalized as desired.

In an example, the silane/siloxane is only partially oxidized into SiOx, e.g. during a plasma process. The polymerized silanes/siloxanes may form SiOx-R, with R giving the functionality of the layer (either a hydrophilic group like amine and alcohol or a hydrophobic group like methyl).

According to a further embodiment, the at least one hydrophobic protection film comprises particles that are (at least partially) embedded in the at least one hydrophobic protection film. In this manner, specific (surface) properties may be provided.

In particular, the particles may improve the integrity, which may be crucial for high frequency applications. Furthermore, the particles may be chosen as plasma etchable to enable patterning and via plating during further production steps.

According to a further embodiment, the particles comprise at least two different shapes. Thereby, the particles may be adapted to specific applications in a flexible manner. The shapes are hereby not limited and may be for example rectangular, circular, or polygonal. Further, the shapes may include a star, a triangle, a sphere, a shape with spikes, etc.

According to a further embodiment, the partially embedded particles affect the surface roughness of the at least one glass barrier layer. Thereby, the (normally smooth) glass barrier layer surface may be adapted to a specific roughness, if desired. For example, a roughness Ra of 300 nm or smaller may thereby be implemented.

According to a further embodiment, the embedded particles comprise a metal oxide, for example SiOz, TiOz, Al₂O₃, fused silica, or zeolithe.

According to a further embodiment, the embedded particles are nonporous particles. According to a further embodiment, the particles can be dry-etched by fluorine plasma gases. Optionally, the particles can be coated to improve the dispersion and the adhesion with the surrounding glass barrier layer.

According to a further embodiment, the embedded particles impart hydrophilic or hydrophobic properties. Depending on the material/surface of the particles, they may provide either hydrophobic or hydrophilic properties, in particular in addition to the glass barrier main surface properties.

According to a further embodiment, the embedded particle diameters are in the micrometer range (1 µm to 1000 µm) and/or nanometer range (1 nm to 1000 nm). This enables a certain design flexibility. Preferably, the particle diameters may be in a range of a surface roughness, for example lower than 500 nm, in particular 300 nm or lower. Further, the particle diameter may be larger than 100 nm, in particular larger than 200 nm.

According to a further embodiment, there can be 10% or more, in particular 15% or more, particles with respect to the glass barrier layer material (volume or mass).

According to a further embodiment, there can be 30% or less, in particular 15% or less, particles with respect to the hydrophobic protection film material (volume or mass) (otherwise, it may be an amorphous layer in an example).

According to a further embodiment, the embedded particles are at least partially embedded in the first surface/portion and/or the first layer and/or in the second surface/portion and/or the second layer. This may provide the advantage that the robust adhesion between the respective layer structure and the hydrophobic protection film is further improved.

In an embodiment, the component carrier is configured as one of the group consisting of a printed circuit board, a substrate (in particular an IC substrate), and an interposer.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

### Brief Description of the Drawings

The aspects defined above and further aspects of the invention are apparent from the examples of embodiment to be described hereinafter and are explained with reference to these examples of embodiment.
Figure 1 shows a component carrier with a hydrophobic protection film according to an exemplary embodiment of the invention.
Figure 2 shows a component carrier with two hydrophobic protection films according to an exemplary embodiment of the invention.
Figures 3A and 3B respectively show a component carrier according to an exemplary embodiment of the invention.
Figure 4 shows a conventional circuit board.
Figures 5A to 5E show a first method of manufacturing a component carrier according to an exemplary embodiment of the invention.
Figures 6A to 6D show a second method of manufacturing a component carrier according to an exemplary embodiment of the invention.
Figures 7A to 7D show a third method of manufacturing a component carrier according to an exemplary embodiment of the invention.
Figures 8A to 8G show a fourth method of manufacturing a component carrier according to an exemplary embodiment of the invention.

### Detailed Description of the Drawings

**Figure 1** shows a component carrier 100 with a hydrophobic protection film 120 according to an exemplary embodiment of the invention. The component carrier 100 comprises a layer stack 101 with alternating electrically conductive layer structures 104 and electrically insulating layer structures 102. A cavity 110 is formed in the stack 101 and the hydrophobic protection film 120 is arranged on an inner surface of the stack 101 that delimits said cavity 110 (here at the bottom).

The hydrophobic protection film 120 partially covers one of the electrically conductive layer structures 104 of the stack 101, at the cavity bottom, and serves as a corrosion protection of a metal surface. In this example, the hydrophobic protection film 120 comprises a T-form (a lower part within opening 122 and an upper part on top of a metal layer 104) in the cross-sectional view through the component carrier 100. The hydrophobic protection film comprises an (organic) polymer, in particular wherein the hydrophobic protection film comprises two or more agents, wherein each agent is configured to provide a specific functionality (e.g. a toughening resin, a cross-linking agent, etc.). Additionally and/or alternatively, the hydrophobic protection film comprises an inorganic material, in particular glass (e.g. silicon dioxide), more in particular wherein the hydrophobic protection film is configured as a glass (barrier) layer.

The layer stack 101 comprises two core layer structures 103 (e.g. (fully) cured (reinforced) resin or glass substrate) for stabilization. For example, the bottom core layer structure 103 can be provided first place and the upper core layer structure 103 can be arranged (after layer build-up) as a lid on top. On top of the lower core layer structure 103, there is arranged said electrically conductive layer structure 104 which also forms the bottom of the cavity 110. Said electrically conductive layer structure 104 is a discontinuous layer with a plurality of openings. One of the openings 122 is located at the center (essentially the middle in the horizontal direction (along x direction) of the bottom of the cavity 110 and is filled with material of the hydrophobic protection film 120. The other openings (located outside of the cavity 110) are filled with electrically insulating material from an electrically insulating layer structure 102, e.g. a prepreg, arranged above the electrically conductive layer structure 104. The side walls 116 of the cavity 110 are free from the hydrophobic protection film 120 in this example.

The vertically straight sidewalls 116 of the cavity 110 are made of metal (e.g. copper) and are directly connected to the electrically conductive layer structure 104 at the bottom of the cavity 110. At the interface of said electrically conductive layer structure 104, the electrically insulating layer structure 102, and the sidewall 116 (at the side facing away from the cavity 110), there is located another electrically insulating material 108, e.g. a release (layer) material or an electrically insulating material 102. This material 108 is a relict from the manufacture process to ensure a high accuracy. Said material 108 is arranged at the same vertical height z as the hydrophobic protection film 120. In particular, the upper surface of the another electrically insulating material 108 is arranged in a coplanar manner to the upper surface of the hydrophobic protection film 120.

On top of the electrically insulating layer structure 102, there is arranged a further electrically conductive layer structure 104 that forms part of the sidewalls 116 of the cavity 110 and comprises a further electrically insulating material 106, in particular a plug paste, preferably with a CTE value smaller than 30 ppm/°C. Said material 106 is in direct contact with the electrically insulating layer structure 102 and can have a wedge-like shape. This material 106 can be used to separate/protect the sidewalls 116 of the cavity 110 from the electrically insulating layer structures 102 of the stack 101.

In between the electrically conductive layer structures 104 on top of the cavity 110, there is located a metal granulate 105, facing the cavity 110 to one side in the horizontal direction x, and facing the electrically insulating layer structure 102 to the other side. Due to this architecture, the cavity 110 comprises a T-shape. The metal granulate 105 can reflect a manufacture step of closing the cavity 110 by placing a roof structure 140 in a lid-like manner on top and onto the metal granulate 105. Furthermore, the metal granulate 105 may prevent that during manufacturing, for example when applying high temperatures (higher than 100 °C), electrically insulating material from electrically insulating layer structure 102 enters the cavity 110. Furthermore, as can be seen in Figure 1, the cavity 110 is delimited on top and bottom, as well as at the sidewalls 116 at least partially by electrically conductive material or electrically conductive layer structures 104.

The cavity 110 is closed on top by a roof structure 140 that comprises a further electrically conductive layer structure 104 onto which the second core layer structure 103 is located. The outermost layer of the stack 101, at the top and at the bottom main surface, is a discontinuous (patterned) electrically conductive layer structure 104, which is e.g. configured for establishing electrical connections to the stack 101. Additionally, an access hole 132 may be formed at the top of the cavity 110 (through the roof structure 140), wherein the access hole 132 (fluidically) connects the cavity 110 to the outside of the layer stack 101 (not shown). The access hole 132 may be free from being in direct contact with a hydrophobic protection film 120/130.

**Figure 2** shows a component carrier 100 with two hydrophobic protection films 120, 130 according to a further exemplary embodiment of the invention. There is a first hydrophobic protection film 120 covering at least part of the inner surface of the stack 101 delimiting the cavity 110 at first side, being the bottom (like in Figure 1), and there is additionally a second hydrophobic protection film 130 covering a part of the inner surface of the stack 101 delimiting the cavity 110 at a second side, being the top, and being opposite to the first side. In comparison to the example of Figure 1, an access hole 132 is formed at the top of the cavity 110 (through the roof structure 140), wherein the access hole 132 (fluidically) connects the cavity 110 to the outside of the layer stack 101. The second hydrophobic protection film 130 closes the access hole 132 with respect to the cavity 110, but can be permeable for air (e.g. by comprising pores). The access hole 132 has sidewalls comprising metal, in particular copper. Alternatively, the sidewalls of the access hole 132 may be free from metal.

The cavity 110 is used in this example for an RF application: an electromagnetic wave (RF wave) is provided via the coupling structure 135 (here an electrical via connection) at the opening 122 (where the first hydrophobic protection film 120 is located) as an inlet. The RF wave propagates then through the cavity 110, and leaves the cavity 110 through the access hole 132, being covered by the second hydrophobic protection film 130, and serving as an output.

**Figures 3A and 3B** respectively show a component carrier 100 according to an exemplary embodiment of the invention.

Figure 3A: in this example, the cavity 110 is configured as a wave guide for guiding an electromagnetic (radiofrequency) wave. The inner sidewalls 116 of the cavity 110, as well as the top and bottom, are covered with metal (e.g. copper). At a first side, being at the bottom of the cavity 110, there is formed an input 122 for the RF waves, while at an opposed second side, being at the top of the cavity 110, there is formed an output 132 for the RF waves. The input 122 is filled with and the (metallic) bottom of the cavity 110 is covered by a first hydrophobic protection film 120. The (metallic) top of the cavity 110 is covered by the second hydrophobic protection film 130, while the output 132 opening is not filled with said second hydrophobic protection film 130. Instead, a plug material 117 (e.g. a sinter paste and/or a non-conductive low HF loss organic material) can be used instead. Preferably, the input 122 and the output 132 may be in close proximity in the horizontal direction x (smaller than 200 µm), but not in direct contact with the sidewalls of the cavity 116.

The cavity 110 is configured here as a fluid (air) cavity with a metal coating at the inside. On top and on bottom of the component carrier 100, there are (directly) arranged antennas, here microstrip antennas 118, 119. While the microstrip antenna 118 at the bottom is configured for feeding the signal into the cavity 110, the microstrip antenna 119 at the top is configured as an outlet of the electromagnetic waves.

Figure 3B: in this example, the input 122 and the output 132 of the cavity 110 are arranged at the same side (not opposite sides) of the component carrier 100. Further, an electronic component (e.g. a semiconductor chip) 180 is mounted at the input 122. In this manner, an electromagnetic wave (or an associated signal) provided by the electronic component 180 can be directly send through the input 122 into the cavity 110. The first hydrophobic protection film 120 covers the bottom of the cavity 110, while the second hydrophobic protection film 130 covers the top of the cavity 110, including the input 122 and the output 132. Yet, in this example, input 122 and output 132 are not filled with hydrophobic protection film material 120, 130.

**Figures 5A to 5E** show a first method of manufacturing a component carrier 100 according to an exemplary embodiment of the invention. In an exemplary embodiment, the cavity 110 is manufactured using an aligned, patterned roof structure 140 (for example an AFSIW) with top and bottom feeding ports 122, 132, in particular suitable for > 3 GHz applications. Manufacture of a cavity 110 can be based on x-ray drilled alignment markers or based on fiducials, e.g. located at the same electrically conductive layer 104 next to the feeding antenna 118.

Figure 5A: in a first step, the cavity 110 is formed in the stack 101. After removing cap material, the (wave guide) cavity 110 is formed. In this example, a (copper) metal granulate (paste) 105 is placed next to the top sidewall regions. In a specific example, metal granulate 105 can be a copper sinter paste e.g. on top of a dielectric low CTE plug paste for forming a dielectric wall 106. This wall can be further used to avoid electrically insulating material, for example prepreg, flowing into the cavity during pressing. There can be a cut-out prepreg and the closing of the roof can be a combination of copper sintering in the copper sinter paste/wall areas and insulating material areas gluing to the top copper.

The roof structure 140 to be placed (in particular with an alignment accuracy < +/- 100 µm) on top of the cavity 110 comprises an electrically insulating layer structure 102, sandwiched between two electrically conductive layer structures 104. Further, the roof structure 140 comprises at the bottom electrically conductive layer structure 104 a second hydrophobic protection film 130, which covers part of the electrically conductive layer structure 104 metal surface in the center (in the horizontal direction x). Furthermore, as can be seen by Figure 5A, at least part of the sidewalls 116 are covered/in direct contact with the hydrophobic protection layer 120 (e.g. (organic) polymer material and/or inorganic material).

As described for Figures 3A and 3B above, there is an opening 122 in the bottom of the cavity 110, which is filled with a first hydrophobic protection film 120 material. The first hydrophobic protection film 120 also covers the metal surface of the cavity bottom. A feeding micro-strip antenna 118 is arranged at the lower main surface of the component carrier 100 and is configured to feed a signal through said opening 122 and into the cavity 110. The feeding antenna 118 is located at the lower main surface of the component carrier 100 and is in close proximity to the cavity 110.

Figure 5B: using a pressing and sintering process, the roof structure 140 is connected to the layer stack 101. In comparison to Figure 5A, the component carrier 100 has been turned upside-down. In a specific example, after pressing of the roof structure on the bottom structure with an alignment accuracy of around +/- 100 µm, the outer layer alignment markers 131 are formed via x-ray drilling process with an accuracy of < +/- 30 µm. Then, a laser cutting process is applied, in particular with support of the x-ray drilled alignment vias 131, to remove part of the top electrically conductive layer structure (copper) (e.g. an etching process is applied in the area of feeding structures) and part of the top electrically insulating layer structure (FR4 material) of the roof structure 140. The second hydrophobic protection film 130 on the inner roof structure 140 of the cavity 110 can act as an etching resist to avoid any chemical substances to enter into said cavity 110. The remaining electrically insulating layer structure 102 can serve e.g. as an etching resist.

Further, an access hole 132 is formed in said electrically insulating layer structure 102, e.g. by laser cutting/drilling, in particular with an alignment accuracy <+/- 30 µm. Alignment marker 131 is here for example an (x-ray drilled) via (in particular with accuracy <+/- 20 µm). The access hole 132 extends through the electrically insulating layer structure 102 and electrically conductive layer structure 104 (through hole) down to (stopped at) the bottom of the electrically conductive layer structure of the roof structure 140. Furthermore, the second hydrophobic protection layer 130 is located (in stack thickness direction) between the access hole 132 and the cavity 110.

Figure 5C: in comparison to Figure 5B, the component carrier 100 has been turned again upside-down. The access hole 132 in the roof structure has been filled with a filler material 117 (e.g. a plug material such as a plug paste or electrically insulating resin such as FR4) that is in direct contact with the second hydrophobic protection film 130 at the cavity 110 side. The antenna structure 119 can be provided by plating (copper) or by patterning an electrically conductive layer structure 104.

Preferably, the hydrophobic protection film 130 (e.g. polymer) of the roof structure 140 avoids that any plug material/paste 117 or copper galvanic chemical substances enter into the cavity 110.

Figure 5D: shown is a variant of Figure 5C, wherein the metallized bottom of the cavity 110 and the access hole 132 (here filled with electrically conductive material 104) are electrically connected by a (blind) via connection as a coupling structure 135 to the respective antenna structure 118, 119. Coupling structure 135 comprises a tapering shape, whereby the tapering direction is oriented towards the cavity 110. In the case of the access hole 132, a further antenna structure 136 is used to guide the signal. The aligned feeding lines 118, 119/136 on top and bottom of the cavity 110 can be configured for high-frequency applications.

Figure 5E: shown is a variant of the component carrier 100 of Figure 5D, wherein the sidewalls of the cavity 110 are electrically insulating and not made of metal. Further, the bottom of the cavity 110 is only partially covered by a patterned metal layer 104. In this example, only the second hydrophobic protection film 130 is used, while the first hydrophobic protection film 120 is omitted.

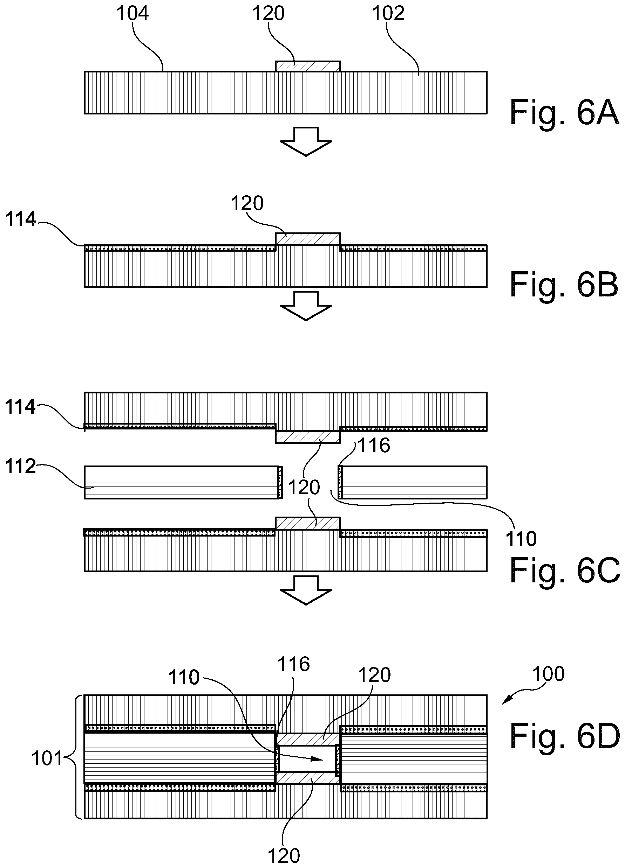

**Figures 6A to 6D** show a second method of manufacturing a component carrier according to an exemplary embodiment of the invention.

Figure 6A: a hydrophobic protection film 120 is formed (by screen printing or (spray) dispensing or plasma application) on a selected electrically conductive layer structure (copper layer) 104. Then, the hydrophobic protection film 120 is (optionally) dried and cured. After printing the hydrophobic protection film 120 as a corrosion protection coating on the selected surfaces 104, the hydrophobic protection film 120 is e.g. cured by a thermal drying process. Any standard drying process can be used, e.g. thermal, infrared or microwave drying. The drying temperature can be for example 100°C to 200° C for 0,5 - 2 h, preferably 150° C for 30 mins.

Figure 6B: a selective micro-etch process is performed to structure the metal (e.g. copper) structure 104 to provide a micro-structured (patterned, roughened) surface 114 for a good adhesion to an electrically insulating layer structure 102, e.g. prepreg. The micro-structured surface 114 has a thickness (in stack thickness direction) smaller than 10 µm, preferably smaller than 5 µm. Furthermore, the level of the exposed micro-structured surface 114 in stack thickness direction is different than the level in stack thickness direction of the interface between the electrically conductive layer structure 104 and the hydrophobic protection layer 120 (in the selected area where the hydrophobic protection layer 120 was formed see description of Figure 6A).

Figure 6C: a cavity 110 (through hole) has been formed in a further electrically insulating layer structure 112. The micro-structured surface 114 is placed on top of the electrically insulating layer structure 112, so that the hydrophobic protection film 120 is located in the cavity 110 and delimits an upper part inside of the cavity 110. Further, there is provided another structure as manufactured in Figure 6B with another micro-structured surface 114 (with another hydrophobic protection film 120 and placed on top of another electrically insulating layer structure 102). Said another structure is placed below the electrically insulating layer structure 112, so that the another hydrophobic protection film 120 is located in the cavity 110, and delimits a lower part inside of the cavity 110. At the end, the stack 101 is press-laminated to close the cavity 110. In other words, there is an attaching process done twice (top and bottom) with respect to the electrically insulating layer structure 112 and hydrophobic material 120 is delimiting the outer surfaces of the cavity. In the example shown, the sidewalls of the cavity 110 are further covered with metal 116 (optional feature).

Figure 6D: there is provided a component carrier 100 with the cavity 110, wherein the top and the bottom of the cavity 110 are formed by the hydrophobic protection film 120 that functions as a corrosion protection for the electrically conductive layer structure 104 surface below.

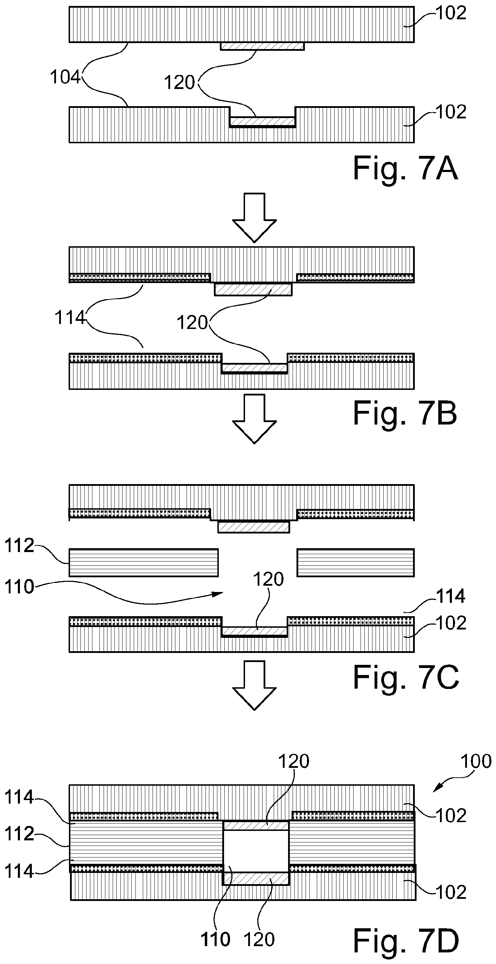

**Figures 7A to 7D** show a third method of manufacturing a component carrier 100 according to an exemplary embodiment of the invention. The method corresponds to the one described for Figures 6A to 6D. Yet, the difference being that there is already a pre-from of the cavity (i.e. a cavity under manufacture that is not considered as the final cavity) formed in the lower component carrier structure with the hydrophobic protection film 120 arranged on (coating) the bottom of said pre-cavity (while in the example of Figures 6A to 6D, the lower component carrier structure comprises no pre-cavity and the hydrophobic protection film 120 is located on the main surface). The pre-cavity forms part of the cavity 110 after stacking the upper component carrier structure, the electrically insulating layer structure 102 (with the through hole as the cavity 110), and the lower component carrier structure, and then laminating them together. In other word, the extension of the cavity 110 in stack thickness direction z is larger than the total extension in stack thickness direction of the further electrically insulating layer structure 112. The final component carrier 100 can be used e.g. for high frequency applications such as antenna, radar, filter, divider, and high frequency feeding structure.

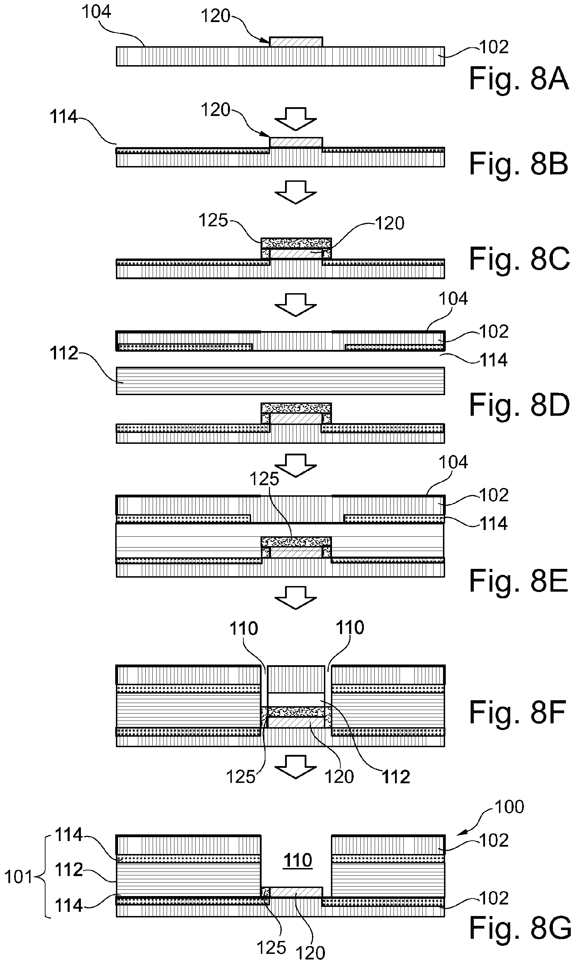

**Figures 8A to 8G** show a fourth method of manufacturing a component carrier 100 according to an exemplary embodiment of the invention.

Figure 8A: a hydrophobic protection film 120 is formed on top of an electrically conductive layer structure 104 that surrounds an electrically insulating layer structure 102 in stack thickness direction (in x-z and y-z direction).

Figure 8B: the electrically conductive layer structure 104 around the hydrophobic protection film 120 is structured (e.g. selective micro-etching) to obtain a structured electrically conductive layer structure 114.

Figure 8C: a release layer (paste) 125 is applied on top of the hydrophobic protection film 120. In a preferred example, the extensions in main direction (x, y direction) of the release layer 125 may be larger than the extension in main direction of the hydrophilic protection film 120.

Figure 8D: during further build-up of the stack, a further electrically insulating layer structure 112 is formed on the structured electrically conductive layer structure 114. The further electrically insulating layer structure 112 is not fully cured (e.g. a prepreg), so that the release layer 125 is pressed into the further electrically insulating layer structure 112. Additionally, there is provided on top another electrically insulating layer structure 102, surrounded by another electrically conductive layer structure 104 (in the x-z and y-z direction), and another structured electrically conductive layer structure 114, both of which electrically conductive layer structures 104, 114 comprise an opening (having at least the height of the release layer 125 in the direction of main extension) above the hydrophobic protection film 120 in the vertical direction z.

Figure 8E: the above described layer structures are pressed together to form a stack 101, so that the release layer 125 is at least partially embedded in the electrically insulating material 112.

Figure 8F: after the stack up is completed, the cavity 110 is formed via laser cutting followed by removing the material inside the cavity 110.

Figure 8G: the release layer 125 can be stripped off from the bottom of the cavity 110 and the hydrophobic protection film 120 can remain in the bottom of the cavity 110 of the final component carrier 100. As indicated, a part of the release layer 125 can remain in the cavity 110. In a further example, the sidewalls of the cavity 110 are covered with metal (copper), e.g. between the hydrophobic protection film 120 and the electrically insulating material 112 or, when portions of the release layer 125 remain: metal between said release layer 125 and the electrically insulating material 112.

### Reference signs

- 100: Component carrier
- 101: Stack
- 102: Electrically insulating layer structure
- 103: Core layer structure
- 104: Electrically conductive layer structure
- 105: Metal granulate
- 106: Further electrically insulating material, plug material
- 108: Another electrically insulating layer structure/material
- 110: Cavity
- 112: Further electrically insulating layer structure
- 114: Patterned electrically conductive layer structure
- 116: Frame, metallized sidewalls
- 117: Filler material, plug
- 118: Feeding antenna strip
- 119: Outlet antenna strip
- 120: Hydrophobic protection film (first, bottom portion)
- 122: Bottom opening, inlet
- 125: Release layer
- 130: Hydrophobic protection film (second, top portion)
- 131: Alignment marker
- 132: Access hole, top opening, outlet
- 135: Feeding/coupling structure
- 136: Further antenna structure
- 140: Roof structure
- 180: Electronic component
- RF: Radiofrequency waves

- 200: Conventional circuit board
- 210: Cavity
- 216: Conventional frame
- 220: Conventional protection layer

## Claims

1. A component carrier (100), which comprises:
a stack (101) comprising at least one electrically conductive layer structure (104) and at least two electrically insulating layer structures (102);
a cavity (110) formed in the stack (101); and
at least one hydrophobic protection film (120) arranged on at least part of an inner surface of the stack (101) delimiting said cavity (110).

2. The component carrier (100) according to claim 1,
wherein the at least one hydrophobic protection film (130) is porous, in particular comprises an open-pores structure.

3. The component carrier (100) according to any one of the preceding claims,
wherein the at least one hydrophobic protection film (120, 130) closes at least one access hole (122, 132) to the cavity (110),
wherein the access hole (132) provides an access from an exterior of the component carrier (100) to the cavity (110).

4. The component carrier (100) according to any one of the preceding claims, wherein the at least one hydrophobic protection film (120, 130) comprises:
a first hydrophobic protection film (120) covering at least part of the inner surface of the stack (101) delimiting the cavity (110) at a first side, and
a second hydrophobic protection film (130) covering at least part of the inner surface of the stack (101) delimiting the cavity (110) at a second side, in particular at the side opposite to the first side.

5. The component carrier (100) according to any one of the preceding claims,
wherein the at least one hydrophobic protection film (120, 130) has a thickness in a range from 50 nm to 50 µm, in particular in a range from 100 nm to 30 µm.

6. The component carrier (100) according to any one of the preceding claims,
wherein at least one side wall of the cavity (110) comprises or consists of metal, in particular copper.

7. The component carrier (100) according to any one of the preceding claims,
wherein a metal granulate (105), in particular a sintered material, is arranged between two electrically conductive layers (104), in particular wherein the metal granulate (105) is in direct contact with the cavity (110).

8. The component carrier (100) according to any one of the preceding claims,
wherein the cavity (110) comprises an input (122) at a first side and an output (132) at a second side, the input (122) and/or the output (132) being associated with and/or in direct contact with the hydrophobic protection film (120, 130).

9. The component carrier (100) according to any one of the preceding claims, wherein the at least one hydrophobic protection film (120) comprises a polymer, in particular wherein the at least one hydrophobic protection film (120) comprises two or more agents, wherein each agent is configured to provide a specific functionality.

10. The component carrier (100) according to claim 9,
wherein the at least one hydrophobic protection film (120, 130) comprises:
a toughening resin,
in particular wherein the toughening resin is provided with a weight percentage in a range from 30% to 80%, in relation to an entire weight of the at least one hydrophobic protection film (120); and/or
a cross-linking agent,
in particular wherein the cross-linking agent is provided with a weight percentage in a range from 5% to 45%, in relation to an entire weight of the at least one hydrophobic protection film (120).

11. The component carrier (100) according to any one of the preceding claims 1 to 8,
wherein the at least one hydrophobic protection film (120) comprises an inorganic material, in particular glass, more in particular wherein the hydrophobic protection film (120) is configured as a glass barrier layer.

12. The component carrier (100) according to claim 11,
wherein the at least one hydrophobic protection film (120) comprises two main surfaces, and
wherein the two main surfaces comprise a different adhesion property.

13. The component carrier (100) according to claim 12,
wherein one of the two main surfaces of the at least one hydrophobic protection film (120) and/or a first layer of the at least one hydrophobic protection film (120) comprises hydrophilic properties;
and/or
wherein the other one of the two main surfaces of the at least one hydrophobic protection film (120) and/or a second layer of the at least one hydrophobic protection film (120) comprises hydrophilic properties or hydrophobic properties.

14. The component carrier (100) according to claim 12 or 13,
wherein one of the two main surfaces of the at least one hydrophobic protection film (120) and/or a first layer of the at least one hydrophobic protection film (120) comprises at least one functional group for providing the hydrophilic properties,
in particular one of the following functional groups: imine, amine, thiol, thioamide, phosphate, hydroxyl, thiazole, imidazole, acrylate, methacrylate, an alcohol group, in particular 3-hydroxypropyl or 2-hydroxyethyl;
and/or
wherein the other one of the two main surfaces of the at least one hydrophobic protection film (120) and/or a second layer of the at least one hydrophobic protection film (120) comprises at least one functional group for providing the hydrophobic properties,
in particular one of the following functional groups: epoxy, allyl, amine, vinyl, alkyl, anhydride, in particular maleic anhydride, furane, pyrrole, thiophene, and/or a cyclic unsaturated alkene, in particular cyclic pentene.

15. A method of manufacturing a component carrier (100), wherein the method comprises:
providing a stack (101) comprising at least one electrically conductive layer structure (104) and at least two electrically insulating layer structure (102);
forming a cavity (110) in the stack (101); and
covering, in particular by printing, at least part of an inner surface of the stack (101), delimiting the cavity (110), with at least one hydrophobic protection film (120).
